# EUROPEAN PATENT SPECIFICATION

(11) **EP 0 262 719 B1**
(45) Date of publication and mention of the grant of the patent: **15.12.1993**
(21) Application number: 87201755.3
(22) Date of filing: 14.09.1987
(51) Int. Cl.: H01L 21/60, H01L 21/90, H01L 21/285

(54) **Method for manufacturing a planar electrical interconnection utilizing isotropic deposition of conductive material**
Verfahren zur Herstellung einer Planarleiterbahn durch isotropes Abscheiden von leitendem Werkstoff
Procédé de fabrication d'une interconnexion planaire par un dépôt isotropique de matériau conducteur

(30) Priority: 30.09.1986 US 913428
(43) Date of publication of application: 06.04.1988
(73) Proprietor: Philips Electronics N.V., 5621 BA Eindhoven (NL)
(72) Inventor: Broadbent, Eliot Kent, NL-5656 AA Eindhoven (NL)
(74) Representative: Houbiers, Ernest Emile Marie Gerlach

(56) References cited:
- EP-A- 0 224 013
- EP-A- 0 234 407
- WO-A-87/04858
- GB-A- 1 286 737
- Proceedings of the 2nd IEEE VLSI Interconnection conference, 25-26 June 1985 pp. 350-356. G.C. Smith: "CVD Tungsten Plugs by In Lite Deposition and Etchback";
- Journal of the Electrochemical Society.: Solid-State Sci. & Technology, May 1983, pp. 1131-1136; H.B. Rothman: "Process for Forming Passivated Metal Interconnection System with a Planar Surface";

## Description

The invention relates to a method of manufacturing a semiconductor device comprising a planar multi-level interconnection system provided by once or repeatedly carrying out the steps of: forming an electrically insulating layer having a largely planar upper surface with openings; forming an electrically conductive planarizing layer having a largely planar upper surface on the insulating layer and in said openings; removing a layer of approximately constant thickness of the material of the conductive planarizing layer in such a way that the underlying electrically insulating layer is no longer covered by said material and only portions of the conductive planarizing layer are retained in the openings.

The vast majority of electrical interconnection systems employed in semiconductor integrated circuits are non-planar. The degree of non-planarity increases as the number of interconnect levels increases. A disadvantage of non-planar systems is that unwanted open circuits may arise as the result of imperfections in metal step coverage. Similarly, weak areas in insulator step coverage can lead to short circuits between different interconnection levels. Photolithographic and etching difficulties in creating narrow conductive lines on rough surfaces severely restrict the density of electronic elements. A planar interconnect system largely overcomes these problems. A relatively easy method for fabricating a planar system is highly desirable.

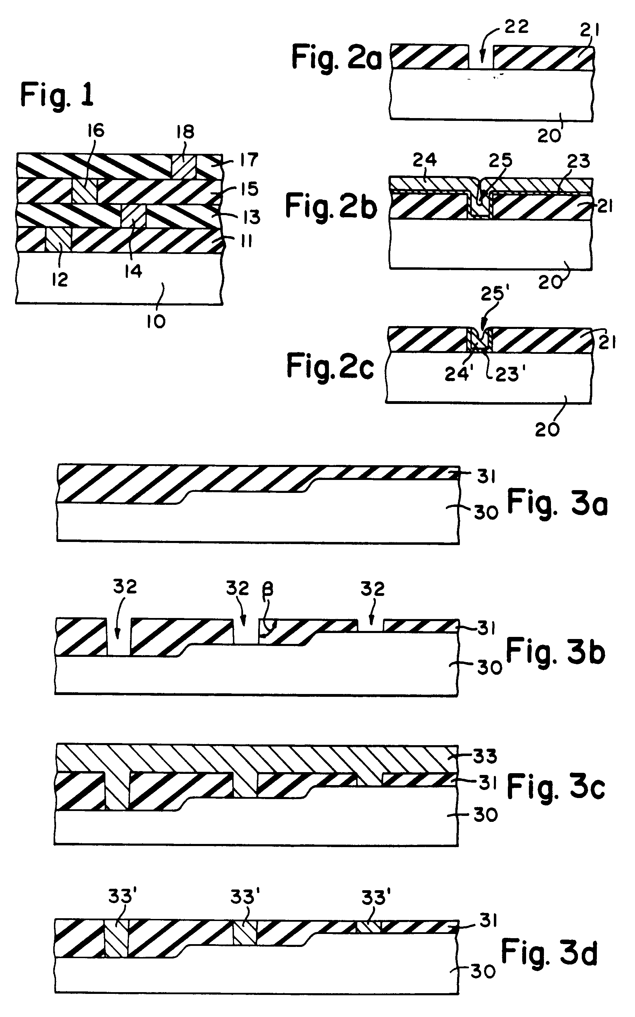

U.K. Patent 1,286,737 discloses a technique for manufacturing a planar multi-level interconnection system. With reference to Fig. 1, the starting material in U.K. Patent 1,286,737 is a semiconductor body 10 that adjoins an insulating layer 11 having a planar upper surface. A set of openings are etched through layer 11. A metal layer is deposited on insulator 11 so as to fill the openings. The metal layer is then etched in such a manner that metal fills the openings but does not extend outside them. Item 12 indicates one of the portions of the remaining metal.

Another insulating layer 13 having a planar upper surface is deposited on the coplanar layer formed by insulator 11 and metal portion 12. Openings are selectively etched through layer 13. A metal layer is deposited and etched in the same way as the previous metal layer. The portions of the remaining metal, represented by item 14, are coplanar with insulator 13. These steps are repeated to form a third planar layer consisting of an insulating layer 15 and a metal portion 16 followed by a fourth planar layer consisting of an insulating layer 17 and a metal portion 18.

The metal-filled openings in layers 11, 13, 15, and 17 could be either vias or grooves. Herein, a "via" means a hole (including a contact opening) whose length and width are approximately the same. A "groove" has a much greater length than width. If, for example, each opening in layer 11 is a via while each opening in layer 13 is a groove, metal portions 12 and 14 form a first interconnection level. In like manner, metal portions 16 and 18 form a second interconnect level.

The interconnect system of Fig. 1 is extremely attractive. However, U.K. Patent 1,286,737 does not disclose the particular details of the metal deposition/etching steps that enable each of the composite metal/insulating layers to be planar.

Rothman, "Process For Forming Metal Interconnection System with a Planar Surface, "J. Electrochem. Soc.: SOLID-STATE SCI. & TECH., May 1983, pp. 1131 - 1136, describes lift-off techniques for depositing an aluminum alloy in cavities in an insulating layer so as to create a composite layer having a planar upper surface. While these lift-off techniques provide relatively good planarity, they involve a large number of complicated and difficult process steps. This limits their usefulness.

Low-pressure chemical vapor deposition (LPCVD) of aluminum is a technique of interest. In Levy et al, "Characterization of LPCVD Aluminum for VLSI Processing," J. Electrochem. Soc.: SOLID-STATE SCI. & TECHN., Sep. 1984, pp. 2175 - 2182, LPCVD aluminum from a tri-isobutyl aluminum source was employed to form an aluminum layer on a dielectric having a rough surface topography. The upper surface of the aluminum layer was largely planar. A disadvantage of this technique is that tri-isobutyl aluminum must be handled very carefully.

Aluminum is the prevalent metal used in interconnects. However, the electromigration resistance of aluminum in pure form or when alloyed with small amounts of copper and/or silicon is relatively low. In addition, aluminum readily interdiffuses with silicon. The resulting degradation of silicon/aluminum junctions leads to undesirably rapid device failure. It does not appear that pure aluminum or conventional aluminum alloys will be capable of meeting the performance requirements for stringent future applications.

A promising interconnect candidate is tungsten whose electromigration resistance is highly superior to that of aluminum. Tungsten has a fairly low resistivity, a high reaction temperature with silicon, a high activation energy, and a high melting temperature. In addition, tungsten acts as a diffusion barrier to silicon and can be readily etched with wet chemicals or plasmas.

A conventional way of depositing tungsten is by LPCVD in which tungsten is supplied by hydrogen redcreduction of tungsten hexafluoride. The deposition can be highly selective in that tungsten nucleates on certain conductors and semiconductors in preference to insulators. See Broadbent et al, "Selective Low Pressure Chemical Vapor Deposition of Tungsten, " J. Electrochem. Soc.: SOLID-STATE SCI. & TECH., June 1984, pp. 1427 - 1433. Also see Saraswat et al, "Selective CVD of Tungsten for VLSI Technology, "Procs. 2nd Int'l Symp. VLSI Sci. & Tech,. Vol. 84-7, 1984, pp. 409 - 419.

Smith, "CVD Tungsten Contact Plugs by In Situ Deposition and Etchback", Procs. 2nd Int'l IEEE VLSI Multilev. Intercon. Conf., 25 - 26 June 1985, pp. 350 - 356, describes the use of non-selectively deposited tungsten for via filling. Figs. 2a - 2c show his processing steps. Referring to Fig. 2a, Smith started with a monocrystalline silicon substrate 20 that adjoined a layer 21 of silicon dioxide having a planar upper surface. A via 22 having nearly vertical sidewalls was etched through layer 21. The aspect ratio - - i.e., via width (or diameter) divided by via depth -- varied from 1.2 to 0.3.

To promote adhesion while avoiding the selective deposition characteristic of tungsten, a thin layer 23 of tungsten silicide was deposited on the structure. A much thicker layer 24 of tungsten with a small percentage of silicon was deposited on layer 23. Both depositions were performed by LPCVD using a vapor consisting of WF₆, H₂, and SiH₄ in which the ratio of tungsten to silicon in each of layers 23 and 24 was controlled by adjusting the WF₆ flow rate. The upper surface of layer 24 was nearly planar as indicated in Fig. 2b.However, a void 25 occurred in layer 24 at the location of via 22 for all aspect ratios studied. I believe that void 25 was produced because the silane (SiH₄) caused the hydrogen to reduce the tungsten hexafluoride in the vapor area away from the deposition surfaces. The tungsten thereby accumulated at a lower rate in the more highly shadowed areas in via 22.

A plasma etch was performed to remove the material of layers 23 and 24 down to the upper surface of insulator 21 as indicated in Fig. 2c. Items 23' and 24' respectively indicate the remaining portions of layers 23 and 24. Void 25 opened into a slot 25' at the top of W portion 24'. Due to the difficulties that would be encountered in providing step coverage on slot 25', its presence is undesirable.

The present invention is a method for fabricating a highly planar electrical interconnection structure using isotropic deposition of a conductive material such as tungsten in filling openings in insulating material. "Isotropic deposition" means that the deposited material accumulates at substantially the same rate on the deposition surfaces regardless of their orientations and locations. The interconnect openings in the present structure typically have nearly vertical sidewalls and may be quite narrow -- e.g., 1 micron or less in width or diameter. Due to the isotropic nature of the deposition, the conductive material in the openings is normally voidfree. This is true even if the aspect ratio is considerably less then 1 -- e.g., as little as 0.3. Because the interconnect structure is planar, it is especially suitable for high-density semiconductor applications.

The starting point for the invention is a substructure which could, for example, be a semiconductor body having various doped regions. An insulating layer having a largely planar upper surface is formed on the substructure. A set of openings are etched through the insulating layer down to the substructure.

A method in accordance with the invention is set out in the appended claim 1 and is characterized in that the step of forming the planarizing layer comprises: depositing an electrically conductive lower layer on the insulating layer and into the openings, the lower layer consisting of a first sublayer that adheres to the insulating layer and to the material exposed through the openings; and then depositing a second sublayer that adheres to the first sublayer and acts as a nucleation surface for the specified material; isotropically depositing a sufficient amount of a specified material from a species in a vapour by a surface controlled chemical reaction in the immediate vicinity of where that material deposits. Because the chemical reaction to free the specified material from the gaseous species occurs at or very close to the deposition surfaces, the material deposits in a uniform manner to fill the openings. The result is that, after deposition of a sufficient amount of the specified material, the upper surface of the upper layer becomes largely planar.

As first sub-layer, a layer of titanium may be used which adheres well to silicon and to silicon-oxide. Because titanium does not form a good nucleation surface for e.g. W, a second sub-layer is provided e.g. by sputter deposition of a thin W-layer.

The specified material is preferably tungsten supplied from tungsten hexafluoride by hydrogen reduction. The vapor carrying the tungsten hexafluoride is silane-free. This appears to account for the isotropic nature of the deposition. The use of tungsten in the present manner leads to a great advance over the prior art.

Fig. 1 is a cross-sectional structural view of a prior art interconnect system.

Figs. 2a, 2b and 2c are cross-sectional structural views representing steps in a known process for depositing tungsten in a via.

Figs. 3a, 3b, 3c, 3d, 3e, 3f, 3g, 3h, 3i, 3j, 3k, 3l, 3m and 3n are cross-sectional structural views representing steps in manufacturing an interconnect system according to the invention.

Fig. 4 is a top view of the structure of Fig. 3b which goes through plane 3b - 3b.

Figs. 5a, 5b, 5c, 5d, 5e are cross-sectional structural views representing preferred steps leading from the structure of Fig. 3b to the structure of Fig. 3c.

Fig. 6 is a top view of the structure of Fig. 3f which goes through plane 3f - 3f.

Fig. 7 is a cross-sectional structural view for an alternative method of finishing the structure of Fig. 3j.

Figs. 8a and 8b are cross-sectional structural views representing an alternative set of steps for completing the structure of Fig. 3k.

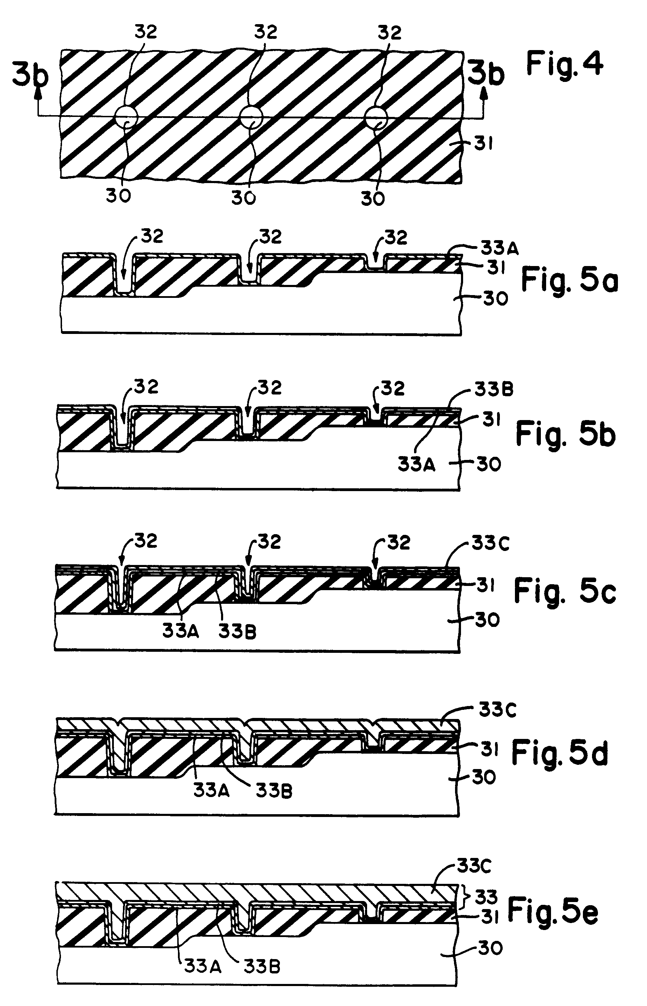

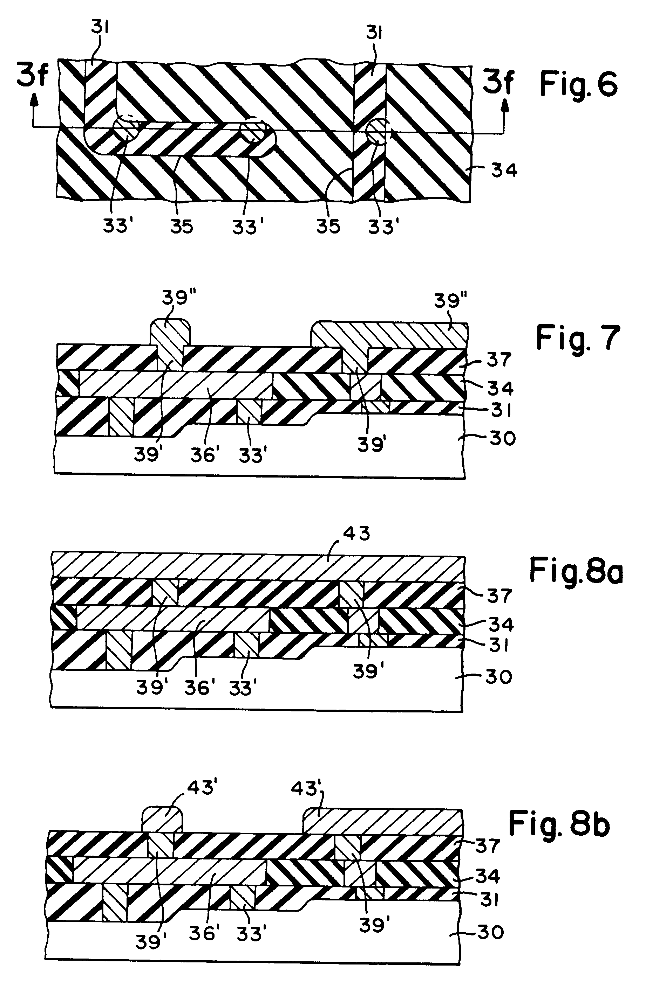

To simplify illustration of the invention, Figs. 4 and 6 employ the shading of the cross-sectional views even though Fig. 4 and 6 are not cross-sectional views.

Like reference symbols are employed in the drawings and in the description of the preferred embodiments to represent the same or very similar item or items.

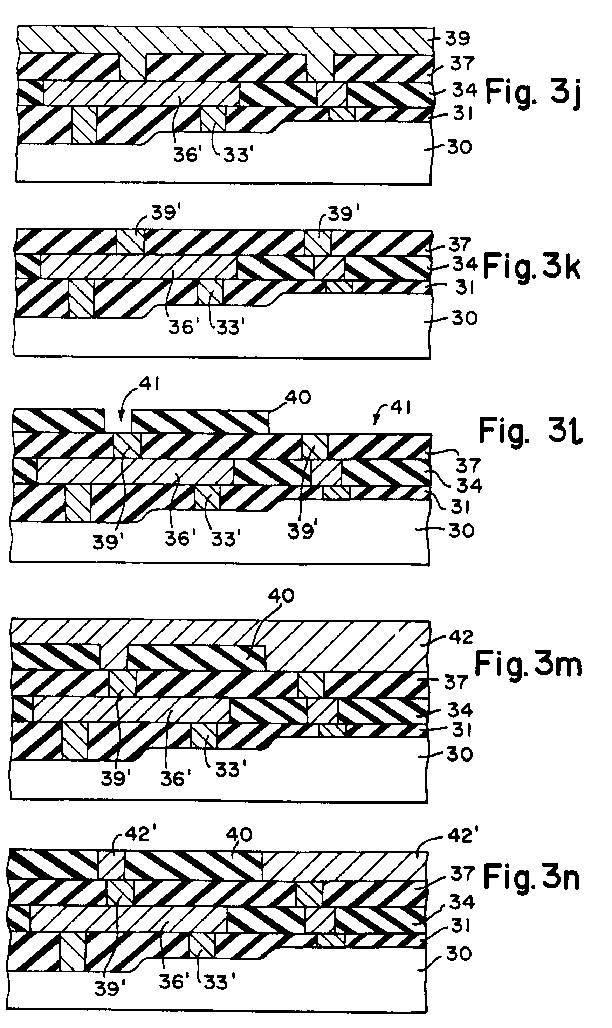

Figs. 3a - 3n illustrate steps for fabricating a two-level largely planar electrical interconnection system for a semiconductor device. By way of explanation without limiting the invention, a surface having a roughness of no more than 0.2 micron would generally be "largely planar". In the following manufacturing discussion, reference to a surface (or other item) as being "planar" means "largely planar".

Photoresist masks (not shown in the drawings) are formed according to conventional photolithographic techniques. Openings, whether vias or grooves, through a layer of silicon dioxide are created by forming a suitably patterned photoresist mask on the oxide layer and then etching with a plasma based on a fluorine-containing gas such as freon. Cleaning steps and other such standard operations are not described below to shorten the description.

The aspect ratio for an opening through a layer of material is the minimum lateral dimension of the opening at one half its depth divided by the depth. The "at-one-half-its-depth" limitation drops out if the opening has nearly vertical sidewalls. For a vertically sidewalled groove, the aspect ratio is groove width divided by depth since the width is the minimum lateral dimension. Similarly, the aspect ratio for a vertically sidewalled circular via is via diameter divided by depth inasmuch as the via width is the diameter for a circular via.

The starting material is a wafer formed with a body 30 consisting of a P-type or N-type monocrystalline silicon semiconductor substrate or of such a substrate with an epitaxial layer grown on it. Various N-type and P-type regions exist in the monocrystalline silicon. Body 30 may also have an interconnection layer of doped polycrystalline silicon that selectively contacts the substrate or epitaxial layer through vias in a layer of silicon dioxide. The details of body 30 are not shown in the drawings. However, its upper surface is typically non-planar as, for example, indicated by the steps shown at the top of body 30 in Fig. 3a.

A first insulating layer 31 of silicon dioxide having a planar upper surface is formed along the upper surface of body 30. This is typically done by depositing silicon dioxide on body 30, forming a layer of exposed photoresist on the oxide, flowing the photoresist so that its upper surface becomes planar, and then removing the photoresist layer with a plasma that etches the photoresist and silicon dioxide at approximately the same rate. The etch removes the steps along the top of the deposited oxide, thereby producing layer 31.

A set of generally circular vias 32 having a diameter of about 1 micron are etched through layer 31 down to body 30 as shown in Fig. 3b. Due to the steps along the top of body 30, vias 32 extend to different depths. The via depth, for example, varies from .0.4 to 2 microns. The sidewalls of vias 32 are nearly vertical. In particular, the angle β between the sidewalls of each via 32 and the upper surface of layer 31 is slightly more than 90°, typically about 95°. Consequently, the via aspect ratio varies from about 2.5 to 0.5. Fig. 4 shows a top view of Fig. 3b.

A first electrically conductive planarizing layer 33 is formed on oxide layer 31 in such a manner that layer 33 has a planar upper surface. See Fig. 3c. Layer 33 is created by an operation involving isotropic LPCVD of tungsten by hydrogen reduction of tungsten hexafluoride. Figs. 5a - 5e illustrate a preferred way for performing this operation.

As indicated above, LPCVD tungsten supplied from WF₆ nucleates (or accumulates) on silicon and metals in preference to silicon dioxide. The selective deposition property must be avoided before tungsten LPCVD can be isotropic. This is accomplished by first depositing a thin electrically conductive sticking layer which acts as a uniform nucleation source for tungsten while simultaneously adhering to the oxide in layer 31 and to the silicon at the bottoms of vias 32. The thickness of the sticking layer is much less than the diameter of vias 32. Depending on β , the ratio of via diameter to sticking layer thickness is normally at least 5 and is typically in the vicinity of 25.

The sticking layer preferably consists of a pair of sublayers 33A and 33B. Referring to Fig. 5a, 20 nm of titanium is deposited on layer 31 and into vias 32 according to conventional sputtering techniques at room temperature in an atmosphere of 0.4 Pa (0.003 torr) of argon to form layer 33A. Titanium adheres well to silicon and to silicon dioxide. Because sputtering is a non-isotropic physical deposition process, the thickness of titanium layer 33A varies somewhat from point to point. Layer 33A is normally thinner in shadowed areas. This is not particularly critical as long as it has no serious discontinuities.

Titanium is not a good nucleation surface for LPCVD tungsten because the fluorine in WF₆ reacts with the titanium to form highly resistive TiF₃. Accordingly, about 20 nm of tungsten is sputter deposited on layer 33A under the above-mentioned conditions to form layer 33B as indicated in Fig. 5b. The tungsten in layer 33B adheres well to titanium and, of course, serves as an excellent nucleation surface for LPCVD tungsten. As with layer 33A, certain parts of W layer 33B are thinner than others. This is likewise not particularly critical as long as layer 33B is continous.

A layer 33C of tungsten is now formed on layer 33B by reducing WF₆ in a low-pressure H₂ environment. The LPCVD operation is initiated by placing the wafer containing the structure of Fig. 5b into a suitable deposition reactor, reducing the reactor pressure to a low value, and heating the wafer to a temperature in the range of 300°C to 500°C. The wafer (or deposition) temperature is preferably 425°C. The reactor is purged with H₂ or an inert gas during the temperature rise. When the desired temperature is reached, the purge is terminated and the reactor is adjusted to a pressure normally less than 6.7 Pa (0.05 torr).

Metered quantities of WF₆ and H₂ are introduced into the reactor. (SiH₄ is specifically avoided) The WF₆ flow rate should be no more than 1,000 standard cm³/minute (SCCM) and is preferably 200 SCCM. The H₂ flow rate should be no more than 8,000 SCCM and is preferably 1,500 SCCM. The reactor pressure during W deposition is controlled so as to be 133.3 Pa (1 torr) or less at which consistent molecular flow occurs. The deposition pressure is preferably 66.7-80 Pa (0.5 - 0.6 torr).

The tungsten deposition proceeds according to the reaction:

WF₆ + 3H₂ → W + 6HF

The reaction is surface controlled under the foregoing deposition conditions. That is, tungsten is freed from WF₆ at or very close to the surfaces where tungsten accumulates to form layer 33C. It appears that very little, if any, tungsten hexafluoride is reduced in the WF₆/H₂ vapor at points distant from the deposition surfaces. The WF₆/H₂ vapor is distributed uniformly along the wafer surface. Also, the temperature is largely the same across the wafer. Consequently, tungsten accumulates on the deposition surfaces at largely the same rate irrespective of their orientations. The deposition is isotropic.

At the preferred flow rates, temperature, and pressure, tungsten deposits at a rate of 50 - 60 nm/minute. The deposition time is preferably 30 minutes. This produces an "equivalent" W thickness of about 1.5 µm.

Figs. 5c - 5e illustrate how layer 33C builds up. Because the deposition is isotropic and because sidewall angle β is slightly greater than 90°, the sidewalls of each low area at vias 32 close in on each other in a uniform manner from the bottom up. The sidewalls of each low area would just meet if the equivalent W thickness equaled a "touching" value slightly less than one half the via diameter (of 1.0 µm). In the present case, the equivalent W thickness is about three times the touching value. Accordingly, the sidewalls of each low area close completely in a void-free manner so that layer 33C has a planar upper surface as indicated in Fig. 5e. Layers 33A, 33B, and 33C of Fig. 5e form planarizing layer 33 of Fig. 3c.

After removing the structure from the deposition reactor, the structure is etched with suitable plasmas to remove a relatively uniform thickness of layer 33 down to the upper surface of oxide 31. This includes removal of the portion of layer 33A lying on the upper surface of layer 31. A fluorine-containing plasma is used to etch the excess tungsten. The excess titanium is removed with a chlorine-based plasma. Both plasmas may use oxygen. The etching may go a few tens of nm below the upper surface of layer 31 without significantly affecting the planarity of the structure from a practical sense. The upper surfaces of the remaining portions 33ʹ of layer 33 are coplanar with the upper surface of layer 31 as shown in Fig. 3d.

In some cases, the upper surface of layer 33 in Fig. 3c may have a non-negligible amount of roughness due to the crystallization properties of the tungsten grains. Portions 33ʹ would normally reflect this roughness. It can be sharply reduced by initially providing layer 33 with a thin photoresist layer whose upper surface is less rough than that of layer 33. The photoresist layer and the upward-protruding parts of layer 33 are removed by etching with an etchant that attacks tungsten and the photoresist at close to the same rate. If this etchant is the above-mentioned fluorine-based plasma, layers 33B and 33C and the photoresist layer can be etched in a single step. Layer 33A is then etched as described above to achieve the structure of Fig. 3d.

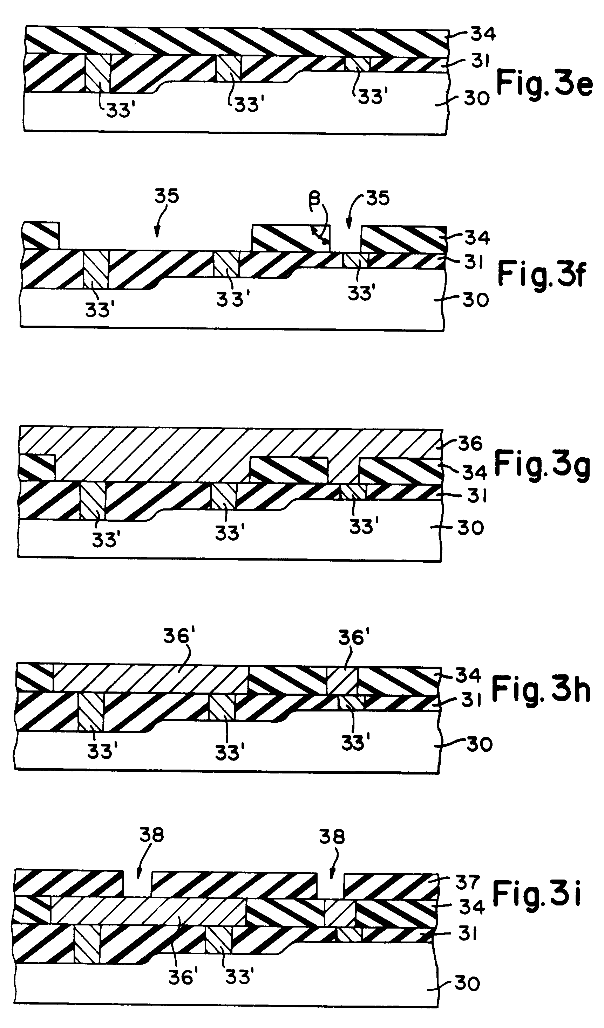

Silicon dioxide is deposited on layer 31 and on metal portions 33' according to conventional techniques to form a second insulating layer 34 having a planar upper surface. See Fig. 3e. Oxide 34 has a thickness of 1.5 - 2.0 µm.

A pattern of grooves 35 corresponding to the desired conductor pattern for the first interconnect level are etched through layer 34 down to portions 33' as depicted in Fig. 3f. The sidewalls of grooves 35 are nearly vertical, sidewall angle β again being about 95°. The groove width is 1 - 1.5 microns. Since the depth of grooves 35 is 1.5 - 2.0 microns, the groove aspect ratio varies from about 1.0 to 0.5. In Fig. 3f, the lefthand groove 35 is shown along its length, while the righthand groove 35 is shown along its width. Fig. 6 shows a top view of Fig. 3f.

A second electrically conductive planarizing layer 36 is formed on layer 34 as depicted in Fig. 3g. Layer 36 is preferably created in precisely the same way as layer 33. In particular, a lower layer consisting of 20 nm of sputtered titanium followed by 20 nm of sputtered tungsten is deposited on layer 34 and in grooves 35. An upper layer is formed by isotropically depositing an equivalent thickness of about 1.5 microns of tungsten on the lower layer. As the tungsten deposits, the sidewalls of each low area at grooves 35 close in a uniform manner from the bottom up. Because the equivalent W thickness is at least twice the touching value, the sidewalls of the lower areas close in a void-free manner to produce a planar upper surface for layer 36.

Using the plasmas employed to etch layer 33, a relatively uniform thickness of layer 36 is removed down to the upper surface of layer 34. Again, the etching may go slightly below the upper surface of layer 34 without causing significant damage to the planarity of the structure. The combination of metal portions 33' and 36' in conjunction with oxide layers 31 and 34 forms a planar interconnect level.

The foregoing steps are now repeated to produce another planar interconnect level as shown in Figs. 3i - 3n. Only a brief discussion of these steps is given here.

A third electrically insulating layer 37 is deposited to a thickness of 0.7 - 1.5 µm and then selectively etched to form vias 38 having a diameter of about 1 µm. A third electrically conductive planarizing layer 39 having a planar upper surface is formed in the manner described above for layer 33. A relatively uniform thickness of layer 39 is removed down to the upper surface of layer 37 to produce the structure shown in Fig. 3k.

A fourth electrically insulating layer 40 is deposited and then selectively etched to form a pattern of grooves 41 corresponding to the desired conductor pattern for the second interconnect level. Grooves 41 have the same depth and width as grooves 35. A fourth electrically conductive planarizing layer 42 is created in the same way as layer 36 so as to have a planar upper surface. A relatively uniform thickness of layer 42 is etched away down to the upper surface of layer 40. In combination with insulating layers 37 and 40, the remaining metal portions 39' and 42' of respective layers 39 and 42 form the sec ond interconnect level as shown in Fig. 3n.

The process of Figs. 3a - 3n thus yields a planar two-level void-free interconnect system. Further planar levels can be added in the same manner.

In some applications, planarizing the upper interconnect level will not lead to a significant increase in device density. A non-planar upper interconnect level may be acceptable if the number of process steps can be reduced.

For example, the structure of Fig. 3j can alternatively be processed in the manner indicated in Fig. 7. Using an appropriate photoresist mask, layer 39 is selectively etched to define the desired pattern for the second interconnect level. The etching may be done with wet chemicals or with the plasmas used to etch layer 33. The remaining conductive portions 39'' of the upper part of layer 39 entirely overlie conductive portions 39' in vias 38.

As another example, the steps shown in Figs. 8a and 8b can be used to finish the structure of Fig. 3k. A blanket layer 43 of an electrical conductor such as aluminum is deposited on layer 37 and metal portions 39'. See Fig. 8a. The undesired portions of layer 43 are etched away using an appropriate photoresist mask. The remaining conductive portions 43' of layer 43 constitute the upper half of the second interconnect levels as shown in Fig. 8b.

The excellent electromigration resistance of tungsten makes it particularly attractive for use in the invention. Much work has also been done in characterizing tungsten for semiconductor applications. Other conductive materials could, however, be used in the invention if they can be deposited isotropically. One candidate is molybdenum. As a "sister" element to tungsten, molybdenum has similar properties. It is available in gaseous MoF₆.

While the invention has been described with reference to particular embodiments, this description is solely for the purpose of illustration and is not to be construed as limiting the scope of the invention claimed below. For example, an experimental structure containing void-free metal-filled grooves of 0.75-µm width and 0.3 aspect ratio has been built. The lowest composite conductive/insulating layer formed according to the invention might contain grooves rather than vias.

The work of Levy et al seems to indicate that there are conditions under which aluminum can be isotropically deposited to achieve a planar surface. It may thus be possible to use aluminum for isotropically filling the openings in the insulating layers. A nucleating layer might be needed to avoid selective aluminum LPCVD. Accordingly, various modifications, changes, and applications may be made by those skilled in the art without departing from the true scope and spirit of the invention as defined by the appended Claims.

## Claims

1. A method of manufacturing a semiconductor device comprising a planar multi-level interconnection system provided by once or repeatedly carrying out the steps of: forming an electrically insulating layer (31, 34, 37, 40) having a largely planar upper surface with openings (32, 35, 38, 41); forming an electrically conductive planarizing layer (33, 36, 39, 42) having a largely planar upper surface on the insulating layer and in said openings; removing a layer of approximately constant thickness of the material of the conductive planarizing layer in such a way that the underlying electrically insulating layer is no longer covered by said material and only portions (33', 36', 39', 42') of the conductive planarizing layer are retained in the openings, **characterized in that** the step of forming the planarizing layer comprises: (1) depositing an electrically conductive lower layer (33A, 33B) on the insulating layer (31) and into the openings (32), the lower layer consisting of a first sublayer (33A) that adheres to the insulating layer (31) and to the material (30) exposed through the openings (32); and then depositing a second sublayer (33B) that adheres to the first sublayer and acts as a nucleation surface for the specified material (33C); isotropically depositing a sufficient amount of a specified material from a species in a vapour by a surface controlled chemical reaction in the immediate vicinity of where that material deposits.

2. A method as claimed in Claim 1, **characterized in that** the specified material (33, 36, 39, 42) consists substantially of tungsten provided by hydrogen reduction.

3. A method as claimed in Claim 2, **characterized in that** the steps of depositing the first and second sublayers respectively comprise depositing titanium and tungsten, the specified material being tungsten, the species being tungsten hexafluoride and the vapour being substantially silane-free.

4. A method as claimed in one of the preceding Claims, **characterized in that** before carrying out the step of removing the planarizing layer, a further layer is provided whose upper surface is less rough than the upper surface of the planarizing layer, after which the further layer and upward protruding parts of the planarizing layer are removed by etching with an etch art that attacks material of the further layer and that planarizing layer at rates not substantially different from each other.

## Patentansprüche

1. Verfahren zum Herstellen einer Halbleiteranordnung mit einem planaren Mehrpegelverbindungssystem, das durch einmaliges oder wiederholtes Durchführen der folgenden Schritte erzeugt wird: die Erzeugung einer elektrisch isolierenden Schicht (31, 34, 37, 40) mit einer weitgehend planaren oberen Fläche mit Öffnungen (32, 35, 38, 41), die Erzeugung einer elektrisch leitenden planarisierenden Schicht (33, 36, 39, 42) mit einer weitgehend planaren oberen Fläche auf der Isolierschicht und in den Öffnungen, das Entfernen einer Schicht ungefähr konstanter Dicke des Materials der leitenden Planarisierungsschicht auf derartige Weise, daß die unterliegende elektrisch isolierende Schicht nicht länger vom Material bedeckt wird und nur Anteile (33', 36', 39', 42') der leitenden planarisierenden Schicht in den Öffnungen zurückbleiben, dadurch gekennzeichnet, daß der Schritt der Erzeugung der planarisierenden Schicht folgende Schritte umfaßt: (1) Das Abscheiden einer elektrisch leitenden unteren Schicht (33A, 33B) auf der Isolierschicht (31) und in den Öffnungen (32), wobei die untere Schicht aus einer ersten Unterschicht (33A) besteht, die an der Isolierschicht (31) und an dem durch die Öffnungen (32) belichteten Material (30) haftet, anschließend das Abscheiden einer zweiten Unterschicht (33B), die an der ersten Unterschicht haftet und als Keimbildungsfläche für das spezifizierte Material (33C) dient, das isotropische Abscheiden einer ausreichenden Menge eines spezifizierten Materials von einer Materialart in einem Dampf durch eine oberflächengesteuerte chemische Reaktion in unmittelbarer Nähe von der Stelle, an der das Material niederschlägt.

2. Verfahren nach Anspruch 1, dadurch gekennzeichnet, daß das spezifizierte Material (33, 36, 39, 42) im wesentlichen aus Wolfram besteht, das durch Wasserstoffreduktion geliefert wird.

3. Verfahren nach Anspruch 2, dadurch gekennzeichnet, daß die Schritte des Abscheidens der ersten und zweiten Unterschichten das Abscheiden von Titan bzw. Wolfram umfassen, wobei das spezifizierte Material Wolfram ist, und die Materialart Wolframhexafluorid und der Dampf im wesentlichen silanfrei sind.

4. Verfahren nach einem der vorangehenden Ansprüche, dadurch gekennzeichnet, daß vor der Durchführung des Schritts zum Entfernen der planarisierenden Schicht eine weitere Schicht angebracht wird, deren obere Fläche weniger rauh ist als die obere Fläche der Planarisierungsschicht, wonach die weitere Schicht und nach oben ausragende Teile der Planarisierungsschicht durch Ätzung mit einem Ätzmittel entfernt werden, das das Material der weiteren Schicht und diese Planarisierungsschicht mit Geschwindigkeiten angreift, die sich nicht wesentlich voneinander unterscheiden.

## Revendications

1. Procédé pour la fabrication d'un dispositif semiconducteur comportant un système d'interconnexion à plusieurs niveaux planaire disposé en une seule fois ou par exécution répétée des étapes de: la formation d'une couche électriquement isolante (31, 34, 37, 40) présentant une surface supérieure largement planaire munie d'ouvertures (32, 35, 38, 41); la formation d'une couche planarisante électriquement conductrice (33, 36, 39, 42) présentant une surface supérieure largement planaire sur la couche isolante et dans lesdites ouvertures; l'enlèvement d'une couche d'une épaisseur pratiquement constante du matériau de la couche planarisante conductrice de façon que la couche électriquement isolante sous-jacente ne soit plus recouverte dudit matériau et que seule des parties (33', 36', 39', 42') de la couche planarisante conductrice soient retenues dans les ouvertures, caractérisé en ce que l'étape de la formation de la couche planarisante comprend: (1) le dépôt d'une couche inférieure électriquement conductrice (33A, 33B) sur la couche isolante (31) et dans les ouvertures (32), la couche inférieure étant constituée par une première sous-couche (33A) qui adhère à la couche isolante 31 et au matériau (30) exposé à travers les ouvertures (32); et puis le dépôt d'une deuxième sous-couche (33B) qui adhère à la première sous-couche et qui agit comme une surface de germination pour le matériau précisé (33C); le dépôt isotrope d'une quantité suffisante de matériau précisé à partir d'une espèce dans une vapeur par réaction chimique commandée par la surface à proximité immédiate de laquelle se dépose le matériau.

2. Procédé selon la revendication 1, caractérisé en ce que le matériau précisé (33, 36, 39, 42) est essentiellement constitué par du tungstène fourni par une réduction par de l'hydrogène.

3. Procédé selon la revendication 2, caractérisé en ce que les étapes de dépôt des première et deuxième sous-couches comprennent respectivement le dépôt de titane et de tungstène, le matériau précisé étant le tungstène, les espèces étant l'hexafluore de tungstène et la vapeur étant pratiquement exempte de silane.

4. Procédé selon l'une des revendications précédentes, caractérisé en ce qu'avant l'exécution de l'étape d'enlèvement de la couche planarisante, une autre couche est disposée et sa surface supérieure est moins rugueuse que la surface supérieure de la couche planarisante, après quoi l'autre couche et les parties saillant vers le haut de la couche planarisante sont enlevées par décapage par un traitement de décapage provoquant l'attaque du matériau de l'autre couche et de la couche planarisante à des vitesses qui ne diffèrent pas essentiellement l'une de l'autre.
